(19) Europäisches Patentamt
European Patent Office
Office européen des brevets

(11) **EP 3 286 595 B1**

(12) **EUROPÄISCHE PATENTSCHRIFT**

(45) Veröffentlichungstag und Bekanntmachung des Hinweises auf die Patenterteilung:
**26.06.2019 Patentblatt 2019/26**

(21) Anmeldenummer: **16712251.4**

(22) Anmeldetag: **10.03.2016**

(51) Int Cl.:
*G02B 27/00* (2006.01)     *G03F 7/20* (2006.01)
*G02B 5/08* (2006.01)      *G02F 1/015* (2006.01)
*G02B 17/08* (2006.01)

(86) Internationale Anmeldenummer:
**PCT/EP2016/055107**

(87) Internationale Veröffentlichungsnummer:
**WO 2016/169696 (27.10.2016 Gazette 2016/43)**

(54) **WELLENFRONTKORREKTURELEMENT ZUR VERWENDUNG IN EINEM OPTISCHEN SYSTEM**

WAVEFRONT CORRECTION ELEMENT FOR USE IN AN OPTICAL SYSTEM

ÉLÉMENT DE CORRECTION DE FRONT D'ONDE DESTINÉ À ÊTRE UTILISÉ DANS UN SYSTÈME OPTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.04.2015 DE 102015207153**

(43) Veröffentlichungstag der Anmeldung:
**28.02.2018 Patentblatt 2018/09**

(73) Patentinhaber: **Carl Zeiss SMT GmbH 73447 Oberkochen (DE)**

(72) Erfinder:
• **BANYAY, Matus
  50226 Frechen (DE)**
• **WEISER, Martin
  74889 Sinsheim (DE)**
• **BITTNER, Boris
  91154 Roth (DE)**

(74) Vertreter: **Frank, Hartmut
Bonsmann Bonsmann Frank
Patentanwälte
Reichspräsidentenstraße 21-25
45470 Mülheim a. d. Ruhr (DE)**

(56) Entgegenhaltungen:
**WO-A1-2004/025335     WO-A2-2008/020899
DE-A1-102010 029 570   US-A- 5 650 632
US-A1- 2004 121 134**

**Beschreibung**

Die vorliegende Anmeldung beansprucht die Priorität der Deutschen Patentanmeldung DE 10 2015 207 153.7, angemeldet am 20. April 2015.

HINTERGRUND DER ERFINDUNG

Gebiet der Erfindung

Die Erfindung betrifft ein Wellenfrontkorrekturelement zur Verwendung in einem optischen System, insbesondere in einem optischen System einer mikrolithographischen Projektionsbelichtungsanlage oder einer Maskeninspektionsanlage.

Stand der Technik

Mikrolithographie wird zur Herstellung mikrostrukturierter Bauelemente, wie beispielsweise integrierter Schaltkreise oder LCDs, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

Maskeninspektionsanlagen werden zur Inspektion von Retikeln für mikrolithographische Projektionsbelichtungsanlagen verwendet.

In für den EUV-Bereich ausgelegten Projektionsobjektiven oder Inspektionsobjektiven, d.h. bei Wellenlängen von z.B. etwa 13 nm oder etwa 7 nm, werden mangels Verfügbarkeit geeigneter lichtdurchlässiger refraktiver Materialien reflektive optische Elemente als optische Komponenten für den Abbildungsprozess verwendet.

Dabei ist es u.a. bekannt, auf einem reflektiven optischen Element eine Wellenfrontkorrekturschicht vorzusehen, deren Dickenprofil typischerweise nachträglich eingestellt wird, um eine im Betrieb des optischen Systems auftretende Wellenfrontaberration zu korrigieren. Des Weiteren ist es auch bekannt, als zusätzliches optisches Wellenfrontkorrekturelement ein in Transmission betriebenes Folienelement einzusetzen, welches über ein variierendes Schichtdickenprofil eine gewünschte Wellenfrontkorrektur bewirkt.

Ein bei dem zuletzt genannten Ansatz in der Praxis auftretendes Problem ist, dass ein zur Erzeugung des variierenden Schichtdickenprofils vorgenommenes Abtragen oder Hinzufügen von Trägermaterial des Folienelementes eine mechanische Destabilisierung zur Folge haben kann.

Ein weiteres, bei den vorstehend beschriebenen Ansätzen auftretendes Problem ist, dass gegebenenfalls eine in der Praxis erforderliche Schutzschicht (z.B. eine Antioxidationsschutzschicht) noch im Nachhinein bzw. nach Erzeugung des jeweiligen variierenden Schichtdickenprofils aufgebracht wird, wodurch wiederum die Genauigkeit der letztendlich durch das Wellenfrontkorrekturelement im optischen System bereitgestellten Wellenfrontmodifikation beeinträchtigt wird.

Zum Stand der Technik wird lediglich beispielhaft auf WO 2013/117343 A1 verwiesen.

ZUSAMMENFASSUNG DER ERFINDUNG

Es ist eine Aufgabe der vorliegenden Erfindung, ein Wellenfrontkorrekturelement zur Verwendung in einem optischen System, insbesondere in einem optischen System einer mikrolithographischen Projektionsbelichtungsanlage oder einer Maskeninspektionsanlage, bereitzustellen, welches die Erzielung einer möglichst präzise einstellbaren Wellenfrontkorrekturwirkung unter zumindest weitgehender Vermeidung der vorstehend beschriebenen Probleme ermöglicht.

Diese Aufgabe wird durch das Wellenfrontkorrekturelement gemäß den Merkmalen der unabhängigen Patentansprüche gelöst.

Ein erfindungsgemäßes Wellenfrontkorrekturelement zur Verwendung in einem optischen System, insbesondere in einem optischen System einer mikrolithographischen Projektionsbelichtungsanlage oder einer Maskeninspektionsanlage, weist auf:

-   eine Trägerfolie, welche im Betrieb des optischen Systems auf die Trägerfolie auftreffende, eine Arbeitswellenlänge des optischen Systems aufweisende elektromagnetische Strahlung zumindest teilweise transmittiert;

-   wobei die Trägerfolie derart ausgestaltet ist, dass der Realteil des komplexen Brechungsindex über einen Nutzbereich der Fläche der Trägerfolie variiert.

Der Erfindung liegt insbesondere das Konzept zugrunde, eine gewünschte Wellenfrontkorrektur dadurch zu erzeugen, dass ein in Transmission betriebenes Wellenfrontkorrekturelement in Form einer Trägerfolie mit einer geeigneten Variation des Realteils des komplexen Brechungsindex ausgestaltet wird. Diesem Ansatz liegt die Überlegung zugrunde, dass eine Beeinflussung der Phase einer durch das Wellenfrontkorrekturelement bzw. die Trägerfolie hindurchtretenden Wellenfront - alternativ oder zusätzlich zu einer etwaigen Dickenvariation - auch über eine Variation des Brechungsindex, genauer gesagt dessen für die Phase den dominierenden Anteil bildenden Realteils, erzielt werden kann.

Aufgrund der erfindungsgemäßen Ausnutzung einer Variation dieses Realteils des komplexen Brechungsindex kann die gewünschte Wellenfrontkorrektur ohne Erfordernis einer Dickenvariation und einer damit gegebenenfalls einhergehenden mechanischen Destabilisierung der Trägerfolie erzielt werden.

Der komplexe Brechungsindex n kann geschrieben werden als

$$n = (1 - \delta) + i \cdot \beta \qquad (1)$$

wobei $(1 - \delta)$ der Realteil und $i \cdot \beta$ der Imaginärteil des komplexen Brechungsindex n ist. In dieser Darstellung beschreibt der dimensionslose Parameter $\delta$ die Abweichung des Realteils des Brechungsindex vom Wert 1 und ist dominierend für die erzielte Phasenänderung, wohingegen der dimensionslose Parameter $\beta$ den Absorptionskoeffizienten bezeichnet. Eine mathematische Beschreibung ist z. B. in D. T. Attwood: "Soft X-Rays and Extreme Ultraviolet Radiation: Principles and Applications", Cambridge, UK: Cambridge University Press (2000) gegeben.

Wenngleich das erfindungsgemäße Wellenfrontkorrekturelement insbesondere ohne Dickenvariation ausgestaltet sein kann und somit in Ausführungsformen der Erfindung eine im Wesentlichen planparallele Geometrie aufweist, ist die Erfindung nicht hierauf beschränkt. So kann in weiteren Ausführungsformen der Erfindung eine Dickenvariation gegebenenfalls auch zusätzlich zu der vorstehend beschriebenen Variation des Brechungsindex (bzw. dessen Realteils) vorhanden sein. Dabei kann die erfindungsgemäße Variation des Brechungsindex insbesondere auch nach Art einer Feinkorrektur genutzt werden, um eine durch eine zunächst bereitgestellte Schichtdickenvariation der Trägerfolie bewirkte Wellenfrontmodifikation mit erhöhter Genauigkeit an eine letztlich gewünschte, zu korrigierende Wellenfront im optischen System anzupassen, oder umgekehrt (d.h. Feinkorrektur über Schichtdickenvariation nach zunächst bereitgestellter Variation des Brechungsindex).

Die vorliegende Erfindung beinhaltet weiter insbesondere das Konzept, die vorstehend beschriebene Variation des Realteils des Brechungsindex in einer Trägerfolie durch Dotierung mit Fremdatomen (d.h. mit Atomen eines zweiten Materials, welches von dem ersten Material der Trägerfolie verschieden ist) zu erzeugen, wobei diese Dotierung einen über einen Nutzbereich der Fläche der Trägerfolie variierenden Dotierungsgrad aufweist.

Die hierbei gemäß der Erfindung erfolgende Bereitstellung einer Wellenfrontmodifikation durch Dotierung des Materials der Trägerfolie mit Fremdatomen hat gegenüber der eingangs beschriebenen, herkömmlichen Wellenfrontmodifikation über eine Schichtdickenvariation den weiteren Vorteil, dass die besagte Dotierung in einem abschließenden Fertigungsschritt und insbesondere nach vorheriger Aufbringung einer Antioxidationsschutzschicht erfolgen kann, da die besagten Fremdatome problemlos durch die jeweilige Antioxidationsschutzschicht oder eine andere dünne Schutzschicht (z.B. im Dickenbereich bis zu 10nm) hindurch zugeführt werden können.

Gemäß einem noch weiteren Vorteil kann eine durch die vorstehend genannte Antioxidationsschutzschicht gegebenenfalls in unerwünschter Weise hervorgerufene Wellenfrontmodifikation bei der erfindungsgemäßen Dotierung im Nachhinein korrigiert werden, so dass die Genauigkeit der letztlich erzielten Wellenfrontmodifikation bzw. eine Anpassung an eine zu kompensierende Wellenfrontaberration im optischen System weiter verbessert werden kann.

In Ausführungsformen kann die Trägerfolie auch eine oder mehrere (Funktions-) Schichten umfassen, die für die Phasenwirkung zuständig sind bzw. die primäre Funktion einer Wellenfront- bzw. Apodisationskorrektur erfüllen.

Gemäß einer Ausführungsform ist die Variation des Realteils des Brechungsindex in dem erfindungsgemäßen Wellenfrontkorrekturelement derart ausgestaltet, dass im Betrieb des optischen Systems für durch das Wellenfrontkorrekturelement transmittierte elektromagnetische Strahlung eine Wellenfrontmodifikation bewirkt wird, welche eine in dem optischen System vorhandene Wellenfrontaberration wenigstens teilweise korrigiert.

Gemäß einer Ausführungsform beträgt die Variation des Realteils des Brechungsindex über einen Nutzbereich der Fläche der Trägerfolie wenigstens 10%, insbesondere wenigstens 20%, weiter insbesondere wenigstens 30%, jeweils bezogen auf den maximalen Wert des Realteils des Brechungsindex.

Gemäß einer Ausführungsform ist die Trägerfolie aus einem ersten Material hergestellt, wobei die Variation des Realteils des Brechungsindex durch Dotierung mit Fremdatomen eines zweiten Materials, welches von dem ersten Material verschieden ist, erzeugt ist.

Gemäß einer Ausführungsform variiert für diese Dotierung der entlang der Dicke der Trägerfolie integrale Dotierungsgrad über einen Nutzbereich der Fläche der Trägerfolie. Hierbei wird unter dem entlang der Dicke der Trägerfolie integralen Dotierungsgrad der in Richtung der Tiefe bzw. in Strahldurchtrittsrichtung aufsummierte Dotierungsgrad verstanden. Mit der Zugrundelegung dieses integralen bzw. aufsummierten Dotierungsgrades wird dem Umstand Rechnung getragen, dass dieselbe Wirkung auf einen Lichtstrahl beim Durchtritt durch die Folie bzw. durch das Wellenfrontkorrekturelement über unterschiedliche Dotierungsprofile erzielt werden kann, da im Ergebnis die integrale Wirkung der Dotierung in Strahldurchtrittsrichtung ausschlaggebend ist.

Die Erfindung betrifft weiter auch ein Wellenfrontkorrekturelement zur Verwendung in einem optischen System, insbesondere in einem optischen System einer mikrolithographischen Projektionsbelichtungsanlage oder einer Maskeninspektionsanlage, mit:

-   einer Trägerfolie aus einem ersten Material, wobei die Trägerfolie im Betrieb des optischen Systems auf die Trägerfolie auftreffende, eine Arbeitswellenlänge des optischen Systems aufweisende elektromagnetische Strahlung zumindest teilweise transmittiert; und

- einer in dieser Trägerfolie vorhandenen Dotierung mit Fremdatomen eines zweiten Materials, welches von dem ersten Material verschieden ist;

- wobei für diese Dotierung der entlang der Dicke der Trägerfolie integrale Dotierungsgrad über einen Nutzbereich der Fläche der Trägerfolie variiert.

Gemäß einer Ausführungsform ist das erste Material aus der Gruppe ausgewählt, welche Silizium (Si), Zirkon (Zr), Molybdän (Mo), Ruthenium (Ru) und Niob (Nb) enthält.

Gemäß einer Ausführungsform ist das zweite Material aus der Gruppe ausgewählt, welche Molybdän (Mo), Ruthenium (Ru), Kohlenstoff (C), Niob (Nb) und Titan (Ti) enthält. Dabei ist das zweite Material vorzugsweise derart gewählt, dass der Indexunterschied (n) zum ersten Material möglichst groß ist.

Gemäß einer Ausführungsform weist die Trägerfolie ferner eine weitere Dotierung mit Fremdatomen eines dritten Materials, welches von dem ersten Material und dem zweiten Material verschieden ist, auf.

Gemäß einer Ausführungsform kompensiert diese weitere Dotierung wenigstens teilweise eine durch die Fremdatome des zweiten Materials induzierte Variation der Intensität der durch das Wellenfrontkorrekturelement transmittierten elektromagnetischen Strahlung über einen Nutzbereich der Fläche der Trägerfolie.

Hierdurch wird dem Umstand Rechnung getragen, dass die in dem erfindungsgemäßen Wellenfrontkorrekturelement zur Erzeugung der gewünschten Variation des Brechungsindex durch Dotierung eingebrachten Fremdatome nicht nur die erwünschte Wellenfrontkorrektur, sondern auch - aufgrund der an diesen Fremdatomen stattfindenden Absorption - ein unerwünschtes Intensitätsprofil (d.h. Intensitätsschwankungen der von dem Wellenfrontkorrekturelement ausgehenden elektromagnetischen Strahlung über den Nutzbereich der Fläche) zur Folge hat. Durch die vorstehend genannte Ausführungsform der Erfindung kann nun bei geeigneter Wahl des Materials erreicht werden, dass einerseits die genannten unerwünschten Intensitätsschwankungen wieder ausgeglichen werden, anderseits aber auch die erwünschte Wellenfrontkorrekturwirkung des Wellenfrontkorrekturelements nicht nennenswert verändert bzw. beeinträchtigt wird.

Mit anderen Worten können durch die besagte weitere Dotierung unerwünschte Apodisierungseffekte (d.h. Effekte aufgrund eines Feldverlaufs in der Intensität) bei gleichzeitiger Aufrechterhaltung der erwünschten Wellenfrontkorrekturwirkung vermieden werden.

Das dritte Material kann aus der Gruppe ausgewählt sein, welche Germanium (Ge), Aluminium (Al), Iod (I), Magnesium (Mg) und Gallium (Ga) enthält. Dabei ist das dritte Material vorzugsweise so gewählt, dass der Indexunterschied (k) zum zweiten Material möglichst groß ist.

Gemäß einer Ausführungsform weist die Trägerfolie eine konstante Dicke auf.

Gemäß einer Ausführungsform weist die Trägerfolie ein Dickenprofil mit variierender Dicke auf.

Gemäß einer Ausführungsform ist auf wenigstens einer Seite der Trägerfolie eine Schutzschicht vorgesehen. Bei dieser Schutzschicht kann es sich z.B. um eine Antioxidationsschutzschicht oder eine Schicht zum Schutz vor strahlungsbedingter oder mechanischer Beschädigung handeln. Die Schutzschicht kann beispielsweise Siliziumdioxid ($SiO_2$) oder Siliziumnitrid ($Si_3N_4$) aufweisen.

Gemäß einer Ausführungsform ist die Trägerfolie an einem reflektiven optischen Element wie z.B. einem EUV-Spiegel vorgesehen. Dabei kann die erfindungsgemäße Trägerfolie beispielsweise als Zwischenschicht im Reflexionsschichtstapel des betreffenden reflektiven optischen Elements ausgestaltet sein. Des Weiteren kann auch eine beliebige (Funktions-) Schicht (z.B. eine Molybdän (Mo)- oder Silizium (Si)-Schicht) des Reflexionsschichtstapels eines EUV-Spiegels selbst dotiert sein, so dass die betreffende dotierte Schicht dann (indem sie eine dotierte Trägerfolie im Sinne der vorliegenden Erfindung darstellt) die erwünschte Wellenfrontkorrektur bewirkt. Je höher in Richtung der optischen Wirkfläche des reflektiven optischen Elements die betreffende Schicht angeordnet ist, umso größer ist die durch diese Schicht erzielte Phasenwirkung, umso größer ist jedoch auch eine infolge der Schicht bewirkte (und somit in Kauf genommene) Abnahme der Reflektivität.

Gemäß einer Ausführungsform ist das Wellenfrontkorrekturelement für eine Arbeitswellenlänge von weniger als 30 nm, insbesondere weniger als 15 nm, ausgelegt. Des Weiteren beträgt die Arbeitswellenlänge vorzugsweise wenigstens 2 nm (da bei Wellenlängen unterhalb von 2 nm diffraktive Optiken eingesetzt werden).

Die Erfindung betrifft weiter einen Spiegel, insbesondere zur Verwendung in einem optischen System einer mikrolithographischen Projektionsbelichtungsanlage oder einer Maskeninspektionsanlage, wobei der Spiegel ein Spiegelsubstrat und einen Reflexionsschichtstapel mit einer Mehrzahl von Schichten aufweist, wobei eine dieser Schichten als Wellenfrontkorrekturelement mit den vorstehend beschriebenen Merkmalen ausgebildet ist.

Die Erfindung betrifft weiter auch ein Verfahren zum Herstellen eines Wellenfrontkorrekturelements zur Verwendung in einem optischen System, insbesondere in einem optischen System einer mikrolithographischen Projektionsbelichtungsanlage oder einer Maskeninspektionsanlage, wobei das Verfahren folgende Schritte aufweist:

- Bereitstellen einer Trägerfolie, welche im Betrieb des optischen Systems auf die Trägerfolie auftreffende, eine Arbeitswellenlänge des optischen Systems aufweisende elektromagnetische Strahlung zumindest teilweise transmittiert; und

- Bearbeiten der Trägerfolie derart, dass eine Variation des Realteils des komplexen Brechungsindex über einen Nutzbereich der Fläche der Trägerfolie erzeugt wird.

Gemäß einer Ausführungsform wird die Trägerfolie aus einem ersten Material hergestellt, wobei das Bearbeiten der Trägerfolie ein Dotieren mit Fremdatomen eines zweiten Materials, welches von dem ersten Material verschieden ist, umfasst.

Gemäß einer Ausführungsform wird auf wenigstens einer Seite der Trägerfolie eine Schutzschicht (z.B. Antioxidationsschutzschicht) ausgebildet.

Gemäß einer Ausführungsform erfolgt das Dotieren mit Fremdatomen eines zweiten Materials nach Ausbilden der Schutzschicht.

Gemäß einer Ausführungsform umfasst das Bearbeiten der Trägerfolie ferner ein Dotieren mit Fremdatomen eines dritten Materials, welches von dem ersten Material und dem zweiten Material verschieden ist.

Zu weiteren bevorzugten Ausgestaltungen und Vorteilen des Verfahrens wird auf die vorstehenden Ausführungen im Zusammenhang mit dem erfindungsgemäßen Wellenfrontkorrekturelement Bezug genommen.

Die Erfindung betrifft weiter ein optisches System einer mikrolithographischen Projektionsbelichtungsanlage, insbesondere eine Beleuchtungseinrichtung oder ein Projektionsobjektiv, sowie auch eine mikrolithographische Projektionsbelichtungsanlage mit wenigstens einem Wellenfrontkorrekturelement mit den vorstehend beschriebenen Merkmalen.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

KURZE BESCHREIBUNG DER ZEICHNUNGEN

Es zeigen:

Figur 1 eine schematische Darstellung zur Erläuterung des Aufbaus eines Wellenfrontkorrekturelements gemäß einer ersten Ausführungsform der Erfindung;

Figur 2 eine schematische Darstellung zur Erläuterung des Aufbaus eines Wellenfrontkorrekturelements gemäß einer weiteren Ausführungsform der Erfindung;

Figur 3 ein Diagramm zur Erläuterung äquivalent wirkender Verteilungen des Dotierungsgrades entlang der Strahlrichtung;

Figur 4 eine schematische Darstellung zur Erläuterung des Aufbaus eines Wellenfrontkorrekturelements gemäß einer weiteren Ausführungsform der Erfindung;

Figur 5a-b schematische Darstellungen, in welchen Werte des komplexen Brechungsindex für unterschiedliche, in einem Wellenfrontkorrekturelement einsetzbare Materialien aufgetragen sind; und

Figur 6 eine schematische Darstellung des möglichen Aufbaus einer für den Betrieb im EUV ausgelegten mikrolithographischen Projektionsbelichtungsanlage.

DETAILLIERTE BESCHREIBUNG BEVORZUGTER AUSFÜHRUNGSFORMEN

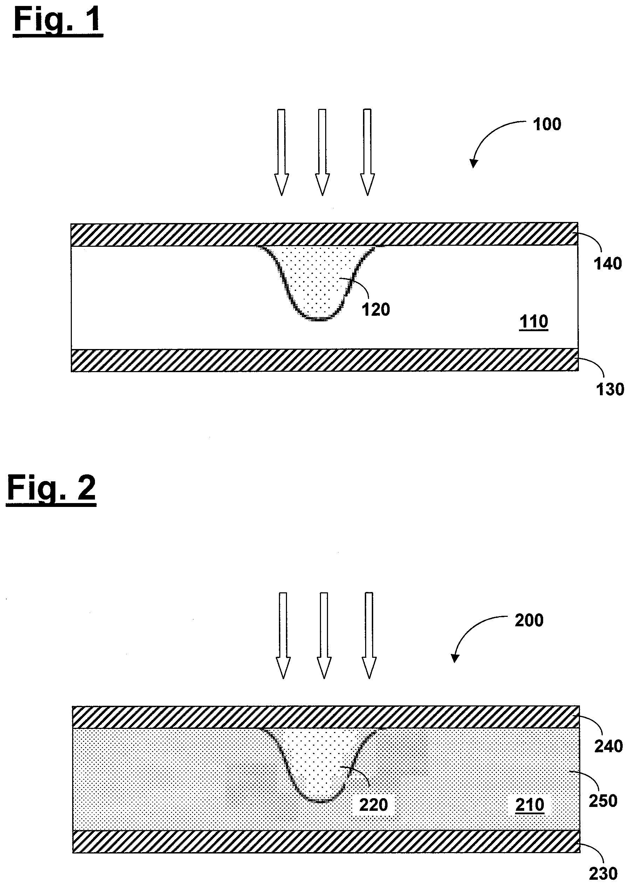

Im Weiteren wird zunächst der mögliche Aufbau eines erfindungsgemäßen Wellenfrontkorrekturelements unter Bezugnahme auf die in Fig. 1 gezeigte schematische Darstellung beschrieben.

Gemäß Fig. 1 weist ein Wellenfrontkorrekturelement 100 insbesondere eine Trägerfolie 110 auf, welche im Ausführungsbeispiel aus Silizium (Si) hergestellt ist und eine beispielhafte Dicke von 200 nm aufweist. Auf der Trägerfolie 110 ist sowohl lichteintrittsseitig als auch lichtaustrittsseitig jeweils eine Schutzschicht (z.B. eine Antioxidationsschutzschicht) 130 bzw. 140 ausgebildet, deren Dicke lediglich beispielhaft im Bereich von 1-2 nm liegen kann und die z.B. aus Siliziumnitrid ($Si_3N_4$) hergestellt sein kann.

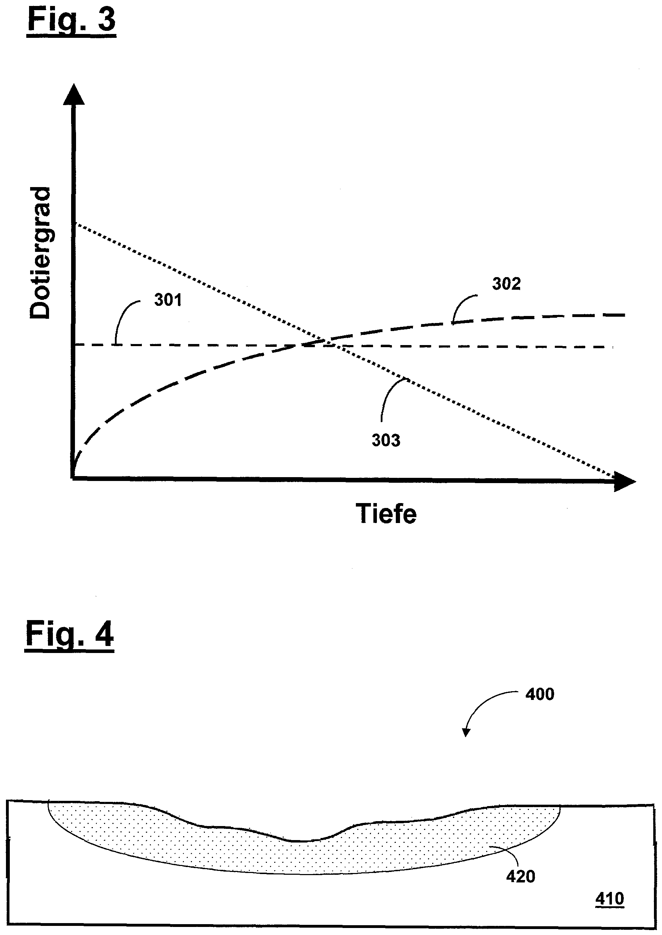

Des Weiteren weist die Trägerfolie 110 eine Variation des Brechungsindex (insbesondere des Realteils des komplexen Brechungsindex) über den Nutzbereich ihrer Fläche auf, wobei diese Variation dadurch erzielt ist, dass die Trägerfolie 110 mit Fremdatomen 120 aus einem zweiten Material dotiert ist, wobei der Dotierungsgrad dieser Dotierung innerhalb der Trägerfolie 110 über den Nutzbereich der Trägerfolie variiert. In Fig. 1 ist lediglich beispielhaft ein gaußförmiger Verlauf dieses Dotierungsgrades gegeben. Wie im Weiteren unter Bezugnahme auf Fig. 3 erläutert wird, sind auch komplexere Verläufe des Dotierungsgrades möglich, wobei insbesondere dieselbe Wirkung auf einen Lichtstrahl beim Durchtritt durch die Folie bzw. durch das Wellenfrontkorrekturelement über unterschiedliche (jedoch "äquivalent wirkende") Dotierungsprofile erzielt werden kann, da im Ergebnis die integrale Wirkung in Strahldurchtrittsrichtung bzw. entlang der Dicke bzw. Tiefe des Wellenfrontkorrekturelements ausschlaggebend ist.

Die Durchführung der besagten Dotierung kann bei Herstellung des Wellenfrontkorrekturelements 100 in einem abschließenden Fertigungsschritt und insbesondere nach vorheriger Aufbringung der betreffenden Schutzschichten 130, 140 erfolgen.

Die erfindungsgemäße Dotierung mit Fremdatomen erfolgt vorzugsweise gezielt mit Fremdatomen eines Materials, welches einen vergleichsweise geringen Einfluss auf die Absorption hat, bei dem somit der Imaginärteil des komplexen Brechungsindex bzw. der Wert β (welcher die Absorption beschreibt) niedrig ist. Hingegen ist ausschlaggebend für den Phasenhub der Unterschied zwischen Trägermaterial und Material der durch Dotierung eingebrachten Fremdatome im Parameter δ, wobei i.d.R. ein möglichst großer Phasenhub gewünscht ist. Generell gilt hierbei der Zusammenhang, dass für zwei Strahlen, welche unterschiedliche Bereiche der Trägerfolie durchlaufen, der maximale Phasenunterschied $\Delta_{max}$ im Wesentlichen gegeben ist durch

$$\Delta_{max} = abs(\delta_1 - \delta_2) * d \qquad (2)$$

wobei $\delta_1$ den Parameter δ für das undotierte Material der Trägerfolie, $\delta_2$ den Parameter δ für das dotierte Material und d die Dicke der Trägerfolie angibt.

Wird beispielsweise als erstes Material der Trägerfolie Silizium (Si) mit einem Wert $\delta_1$= 0.001 und als zweites Material der durch Dotierung eingebrachten Fremdatome Molybdän (Mo) mit einem Wert $\delta_2$= 0.076 verwendet, so ergibt sich für eine beispielhafte Dicke der Trägerfolie von 100nm für den maximal erzielbaren Phasenhub ein Wert $\Delta_{max}$=(0.076-0.001)*100nm=7.5nm, was bei einer Arbeitswellenlänge von λ=13.5nm etwa einem maximal erzielbaren Phasenhub von π entspricht. Durch Wahl einer größeren Dicke der Trägerfolie kann dieser Wert auch entsprechend vergrößert werden, z.B. auf etwa 2π bei einer Dicke der Trägerfolie von 200nm etc. Die Einstellung des maximalen Phasenhubs entspricht hierbei einer 100%-Dotierung, wobei z.B. bei einer 25%-Dotierung entsprechend ein Viertel dieses Wertes erzielt wird.

Im Rahmen der Erfindung sind komplexere Verteilungen hinsichtlich des Dotierungsgrades möglich, da es lediglich auf die integrale Wirkung in Strahldurchtrittsrichtung ankommt. Fig. 3 zeigt in einem qualitativen Diagramm Beispiele für verschiedene, äquivalent wirkende Dotierungen in Strahldurchtrittsrichtung, wobei jeweils der Dotierungsgrad als Funktion der Tiefe des Wellenfrontkorrekturelements aufgetragen ist. Graph 301 zeigt eine homogene Dotierung entlang der Tiefe, Graph 303 einen linear abnehmenden Verlauf und Graph 302 einen komplexeren Verlauf mit entlang der Tiefe zunehmenden Dotierungsgrad. Da in dem Diagramm die integralen Flächen unter den Graphen jeweils gleich groß sind, ist auch die Wirkung auf den Lichtstrahl beim Durchtritt durch die Folie bzw. durch das Wellenfrontkorrekturelement identisch. Des Weiteren können auch verschiedene Verläufe etwa gemäß Fig. 3 über den Nutzbereich der Fläche der Trägerfolie bzw. des Wellenfrontkorrekturelements kombiniert werden.

Ein für die erfindungsgemäße Dotierung geeignetes Verfahren ist die Ionenimplantationstechnik, wobei Dotierungsgrade beispielsweise im Bereich von 10% bis 20% eingestellt werden können. Zu dem Verfahren der Ionenimplantationstechnik wird lediglich beispielhaft auf die Publikationen H. Ryssel, I. Ruge: "Ion Implantation", J. Wiley & Sons, Chichester 1986, ISBN 0-471-10311-X sowie "Handbook of ion beam processing technology", herausgegeben von J.J. Cuomo, S.M. Rossnagel, HR Kaufman Noyes Publications 1989 verwiesen.

Die Energie der bei der Dotierung implantierten Fremdatome kann beispielsweise je nach Material der Fremdatome im Bereich von 1keV bis 100keV liegen. Die bei der Implantation eingestellten Ionenflüsse können unter Berücksichtigung der thermischen Belastbarkeit der Trägerfolie (und unter Vermeidung einer gegebenenfalls zu einem Zerreißen führenden übermäßigen Erhitzung) geeignet gewählt werden, beispielsweise im Bereich von wenigen pA/cm$^2$ bis zu mehreren 10μA/cm$^2$.

Gemäß Fig. 1 weist die Trägerfolie 110 bzw. das Wellenfrontkorrekturelement 100 eine konstante Dicke auf, so dass insbesondere eine gegebenenfalls mit einer mechanischen Destabilisierung einhergehende, bereichsweise Abtragung von Material der Trägerfolie vermieden wird. Die Erfindung ist jedoch hierauf nicht beschränkt, wobei in weiteren Ausführungsformen, wie in Fig. 4 schematisch dargestellt, eine Trägerfolie 410 auch ein Dickenprofil mit variierender Dicke aufweist. Im Übrigen sind in Fig. 4 zu Fig. 1 analoge bzw. im Wesentlichen funktionsgleiche Komponenten mit um "300" erhöhten Bezugsziffern bezeichnet. Gemäß Fig. 4 wird somit die Phasen- bzw. Wellenfrontwirkung eines variierenden Dickenprofils der Trägerfolie 410 mit der erfindungsgemäßen Phasen- bzw. Wellenfrontwirkung aufgrund der Dotierung mit Fremdatomen 420 kombiniert, wobei insbesondere eine Feineinstellung der Phasenwirkung bzw. Wellenfrontmodifikation durch besagte Dotierung erfolgen kann.

Fig. 2 zeigt eine weitere Ausführungsform eines erfindungsgemäßen Wellenfrontkorrekturelements 200, wobei im Vergleich zu Fig. 1 analoge bzw. im Wesentlichen funktionsgleiche Komponenten mit um "100" erhöhten Bezugsziffern bezeichnet sind.

Das Wellenfrontkorrekturelement 200 gemäß Fig. 2 unterscheidet sich von demjenigen aus Fig. 1 dadurch, dass zusätzlich eine weitere ("sekundäre") Dotierung aus Fremdatomen 250 eines dritten Materials vorgesehen ist, welche dazu dient, eine durch die ("primäre") Dotierung mit den Fremdatomen 220 des zweiten Materials induzierte, unerwünschte Intensitätsvariation über einen Nutzbereich der Fläche der Trägerfolie 210 wenigstens teilweise zu kompensieren.

Wie in Fig. 2 lediglich schematisch angedeutet, ist die besagte sekundäre Dotierung mit Fremdatomen 250 insofern invers bzw. komplementär zu der primären Dotierung aus Fremdatomen 220 ausgestaltet, als sich im Ergebnis ein möglichst konstanter Transmissionsverlauf über das Feld bzw. über den Nutzbereich der Fläche des Wellenfrontkorrekturelements 200 ergibt. Auch hinsichtlich dieser sekundären Dotierung gilt das vorstehend unter Bezug auf Fig. 3 beschriebene Prinzip, wonach dieselbe Wirkung auf einen Lichtstrahl beim Durchtritt durch die Folie bzw. durch das Wellenfrontkorrekturelement über unterschiedliche (jedoch "äquivalent wirkende") Dotierungen in Strahldurchtrittsrichtung bzw. entlang der Tiefe erzielt werden kann, da im Ergebnis die integrale Wirkung in Strahldurchtrittsrichtung ausschlaggebend ist.

Des Weiteren ist die Erfindung hinsichtlich der sekundären Dotierung nicht auf die vorstehend anhand von Fig. 2 beschriebene inverse bzw. zur primären Dotierung komplementäre Dotierung beschränkt. So kann in weiteren Ausführungsformen die besagte sekundäre Dotierung auch in Bereichen vorhanden sein, in denen sich bereits auch die primäre Dotierung befindet.

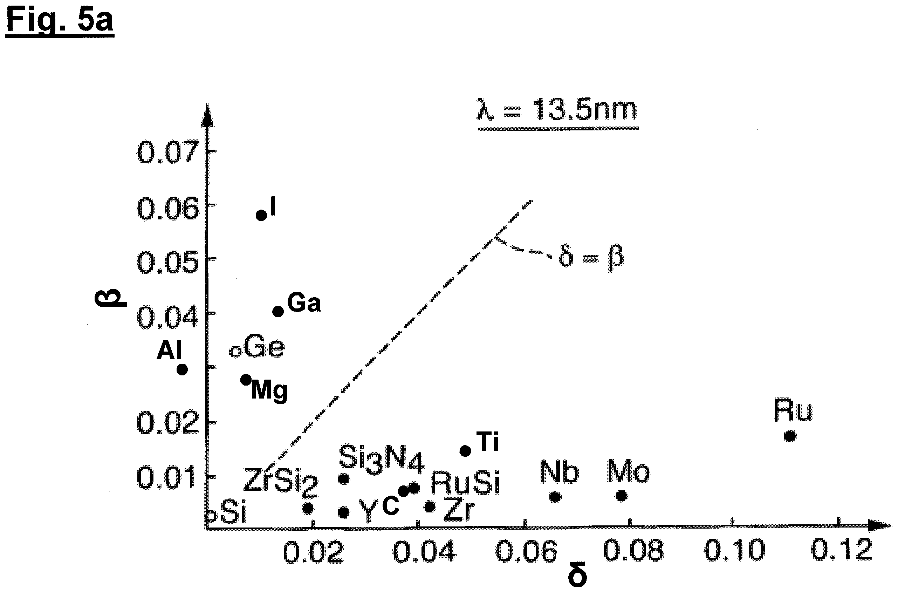

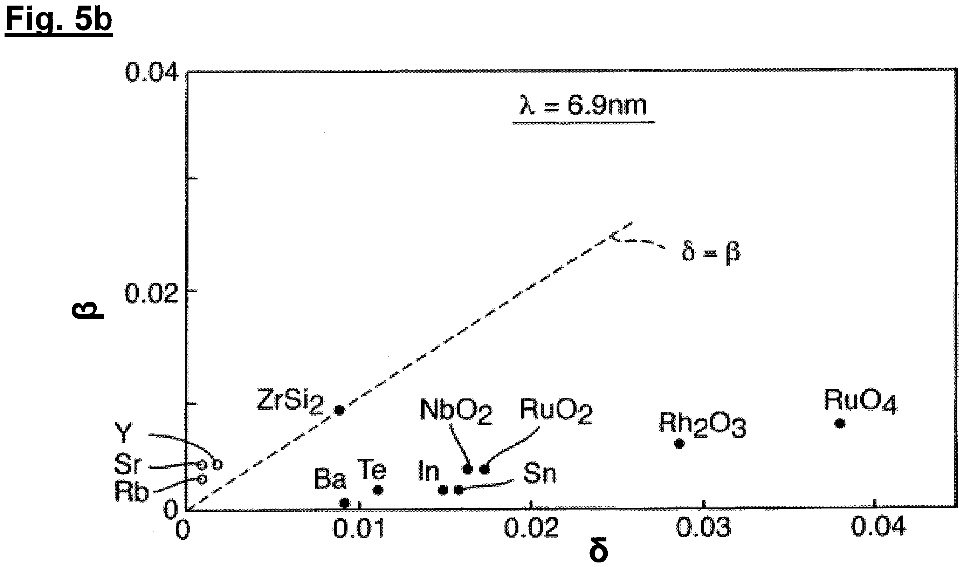

In Fig. 5a und 5b sind Werte des komplexen Brechungsindex für weitere unterschiedliche, in einem erfindungsgemäßen Wellenfrontkorrekturelement einsetzbare Materialien aufgetragen, wobei in Fig. 5a die entsprechenden Werte für ausgewählte Materialien bei einer Arbeitswellenlänge von $\lambda = 13.5$nm und in Fig. 5b die entsprechenden Werte für ausgewählte Materialien bei einer Arbeitswellenlänge von $\lambda = 6.9$nm aufgetragen sind. Grundsätzlich eignen sich für die erfindungsgemäße primäre Dotierung mit Fremdatomen Materialien mit einem vergleichsweise großen Phasenhub (mit vergleichsweise großem $\delta$-Wert), wobei zugleich der $\beta$-Wert einen kritischen Wert von etwa 0.01 bis 0.02 zur Begrenzung von Transmissionsverlusten (insbesondere bei limitierter Quellleistung) nicht überschreiten sollte. Geeignete Materialien hierfür sind bei $\lambda = 13.5$nm insbesondere Molybdän (Mo), Ruthenium (Ru), Kohlenstoff (C), Niob (Nb) und Titan (Ti), wobei der jeweilige $\delta$-Wert und $\beta$-Wert für diese Materialien bei $\lambda = 13.5$nm in Tabelle 1 angegeben ist:

Tabelle 1:

| Material | $\delta$-Wert | $\beta$-Wert |
|---|---|---|
| Molybdän (Mo) | 0.076200545 | 0.0064345 |
| Ruthenium (Ru) | 0.113630742 | 0.017061159 |
| Kohlenstoff (C) | 0.038424399 | 0.006904726 |
| Niob (Nb) | 0.066245429 | 0.005195308 |
| Titan (Ti) | 0.048080225 | 0.014182366 |

Geeignete Materialien für die anhand von Fig. 2 beschriebene sekundäre Dotierung (mit Fremdatomen 250) zur Transmissionskorrektur der Gesamtwellenfront zeichnen sich durch einen möglichst geringen Phasenhub bei zugleich vergleichsweise großer Absorption aus, wobei der $\delta$-Wert wesentlich kleiner als 0.01 und der $\beta$-Wert wesentlich größer als 0.01 sein sollte. Beispielhaft geeignete Materialien für diese sekundäre Dotierung bei

$\lambda = 13.5$nm sind Germanium (Ge), Aluminium (Al), Iod (I), Magnesium (Mg) und Gallium (Ga), wobei der jeweilige $\delta$-Wert und $\beta$-Wert für diese Materialien bei $\lambda = 13.5$nm in Tabelle 2 angegeben ist:

Tabelle 2:

| Material | $\delta$-Wert | $\beta$-Wert |
|---|---|---|
| Germanium (Ge) | 0.005335126 | 0.032091424 |
| Aluminium (Al) | -0.002843466 | 0.029659614 |
| Iod (I) | 0.012140397 | 0.058258455 |
| Magnesium (Mg) | 0.007833972 | 0.027692031 |
| Gallium (Ga) | 0.014838818 | 0.03930077 |

Da durch den Imaginärteil des komplexen Brechungsindex die Absorptionseigenschaften des Materials definiert werden, kann durch die anhand von Fig. 2 beschriebene Ausführungsform erreicht werden, dass bei einer sekundären Dotierung mit zur primären Dotierung "inversem" bzw. komplementärem Dotiermuster der durch die primäre Dotierung in unerwünschter Weise induzierte Feldverlauf in der Intensität gerade kompensiert wird.

Wenngleich das erfindungsgemäße Wellenfrontkorrekturelement insbesondere als Wellenfrontkorrekturfolie zusätzlich in das betreffende optische System zur Erzielung einer gewünschten Wellenfrontmodifikation quasi "freistehend" eingebracht werden kann, sollen in weiteren Ausführungsformen auch Ausgestaltungen als von der Erfindung umfasst gelten, bei welchen das Wellenfrontkorrekturelement an einem reflektiven optischen Element (insbesondere einem EUV-Spiegel) vorgesehen ist, wobei die erfindungsgemäße Trägerfolie beispielsweise - wie bereits erläutert - als Zwischenschicht im Reflexionsschichtstapel des betreffenden reflektiven optischen Elements ausgestaltet sein kann. Möglich ist auch eine Dotierung einer beliebigen (Funktions-) Schicht (z.B. eine Molybdän (Mo)- oder Silizium (Si)-Schicht) des Reflexionsschichtstapels eines EUV-Spiegels selbst, so dass die betreffende, erfindungsgemäß dotierte Schicht dann die erwünschte Wellenfrontkorrektur bewirkt. Je höher in Richtung der optischen Wirkfläche des EUV-Spiegels die betreffende Schicht angeordnet ist, umso größer ist die durch diese Schicht erzielte Phasenwirkung, umso größer ist jedoch auch eine infolge der Schicht bewirkte (und somit in Kauf genommene) Abnahme der Reflektivität.

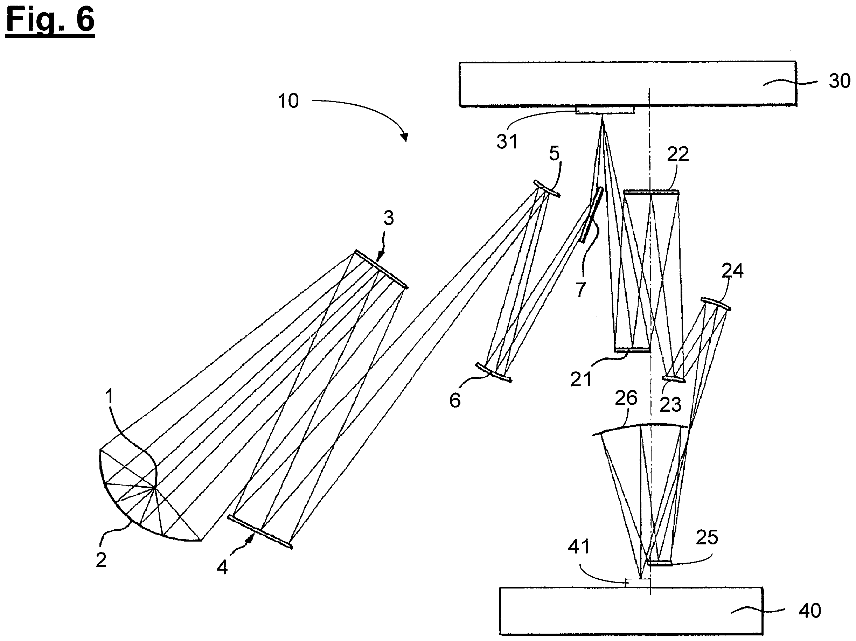

Fig. 6 zeigt eine schematische Darstellung einer beispielhaften für den Betrieb im EUV ausgelegten Projektionsbelichtungsanlage, welche ein erfindungsgemäßes Wellenfrontkorrekturelement aufweisen kann.

Gemäß Fig. 6 weist eine Beleuchtungseinrichtung in einer für EUV ausgelegten Projektionsbelichtungsanlage 10 einen Feldfacettenspiegel 3 und einen Pupillenfacettenspiegel 4 auf. Auf den Feldfacettenspiegel 3 wird das Licht einer Lichtquelleneinheit, welche eine lediglich beispielhaft eine Plasmalichtquelle 1 und einen Kollektorspiegel 2 umfasst, gelenkt. In weiteren Ausführungsformen kann auch z.B. ein Freie-Elektronen-Laser (FEL) als Lichtquelle verwendet werden. Im Lichtweg nach dem Pupillenfacettenspiegel 4 sind ein erster Teleskopspiegel 5 und ein zweiter Teleskopspiegel 6 angeordnet. Im Lichtweg nachfolgend ist ein Umlenkspiegel 7 angeordnet, der die auf ihn treffende Strahlung auf ein Objektfeld in der Objektebene eines sechs Spiegel 21-26 umfassenden Projektionsobjektivs lenkt. Am Ort des Objektfeldes ist eine reflektive strukturtragende Maske 31 auf einem Maskentisch 30 angeordnet, die mit Hilfe des Projektionsobjektivs in eine Bildebene abgebildet wird, in welcher sich ein mit einer lichtempfindlichen Schicht (Photoresist) beschichtetes Substrat 41 auf einem Wafertisch 40 befindet. In der Projektionsbelichtungsanlage kann wenigstens ein erfindungsgemäßes Wellenfrontkorrekturelement gemäß den vorstehend beschriebenen Ausführungsformen angeordnet sein, wobei die Position des Wellenfrontkorrekturelements abhängig von den konkreten Gegebenheiten (z.B. Bauraum sowie Ausmaß der erforderlichen Korrektur) geeignet gewählt werden kann. Des Weiteren kann ein erfindungsgemäßes Wellenfrontkorrekturelement wie schon erwähnt entweder als freistehendes Wellenfrontkorrekturelement ausgestaltet sein oder auch an wenigstens einem der in der Beleuchtungseinrichtung oder im Projektionsobjektiv vorhandenen Spiegel vorgesehen sein.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen möglich sind, und die Reichweite der Erfindung nur im Sinne der beigefügten Patentansprüche beschränkt ist.

**Patentansprüche**

1. Wellenfrontkorrekturelement zur Verwendung in einem optischen System, insbesondere in einem optischen System einer mikrolithographischen Projektionsbelichtungsanlage oder einer Maskeninspektionsanlage, mit:

   • einer Trägerfolie (110, 210, 410), welche im Betrieb des optischen Systems auf die Trägerfolie auftreffende, eine Arbeitswellenlänge des optischen Systems aufweisende elektromagnetische Strahlung zumindest teilweise transmittiert;
   • wobei die Trägerfolie (110, 210, 310) derart ausgestaltet ist, dass der Realteil des komplexen Brechungsindex über einen Nutzbereich der Fläche der Trägerfolie (110, 210, 410) variiert;
   • wobei die Trägerfolie (110, 210, 410) aus einem ersten Material hergestellt ist, welches aus der Gruppe ausgewählt ist, welche Silizium (Si), Zirkon (Zr), Molybdän (Mo), Ruthenium (Ru) und Niob (Nb) enthält, und wobei die Variation des Realteils des Brechungsindex durch Dotierung mit Fremdatomen (120, 220, 420) eines zweiten Materials erzeugt ist;
   • wobei die Trägerfolie (110, 210, 410) ferner eine weitere Dotierung mit Fremdatomen (250) eines dritten Materials, welches von dem ersten Material und dem zweiten Material verschieden ist, aufweist, wobei diese weitere Dotierung eine durch die Fremdatome (120, 220, 420) des zweiten Materials induzierte Variation der Intensität der durch das Wellenfrontkorrekturelement (100, 200, 400) transmittierten elektromagnetischen Strahlung über einen Nutzbereich der Fläche der Trägerfolie (110, 210, 410) wenigstens teilweise kompensiert.

2. Wellenfrontkorrekturelement nach Anspruch 1, **dadurch gekennzeichnet, dass** die Variation des Realteils des Brechungsindex über einen Nutzbereich der Fläche der Trägerfolie (110, 210, 410) wenigstens 10%, insbesondere wenigstens 20%, weiter insbesondere wenigstens 30%, jeweils bezogen auf den maximalen Wert des Realteils des Brechungsindex, beträgt.

3. Wellenfrontkorrekturelement nach Anspruch 1 oder 2, **dadurch gekennzeichnet, dass** für die Dotierung mit Fremdatomen (120, 220, 420) des zweiten Materials der entlang der Dicke der Trägerfolie (110, 210, 410) integrale Dotierungsgrad über einen Nutzbereich der Fläche der Trägerfolie (110, 210, 410) variiert.

4. Wellenfrontkorrekturelement nach einem der Ansprüche 1 bis 3, **dadurch gekennzeichnet, dass** das zweite Material aus der Gruppe ausgewählt ist, welche Molybdän (Mo), Ruthenium (Ru), Kohlenstoff (C), Niob (Nb) und Titan (Ti) enthält.

5. Wellenfrontkorrekturelement nach einem der vorhergehenden Ansprüche, **dadurch gekennzeichnet, dass** das dritte Material aus der Gruppe ausgewählt ist, welche Germanium (Ge), Aluminium (Al), Iod (I), Magnesium (Mg) und Gallium (Ga) enthält.

6. Wellenfrontkorrekturelement nach einem der Ansprüche 1 bis 5, **dadurch gekennzeichnet, dass** die Trägerfolie (110, 210) eine konstante Dicke aufweist.

**7.** Wellenfrontkorrekturelement nach einem der Ansprüche 1 bis 5, **dadurch gekennzeichnet, dass** die Trägerfolie (410) ein Dickenprofil mit variierender Dicke aufweist.

**8.** Wellenfrontkorrekturelement nach einem der vorhergehenden Ansprüche, **dadurch gekennzeichnet, dass** auf wenigstens einer Seite der Trägerfolie eine Schutzschicht (130, 140, 230, 240) vorgesehen ist.

**9.** Wellenfrontkorrekturelement nach einem der vorhergehenden Ansprüche, **dadurch gekennzeichnet, dass** die Trägerfolie an einem reflektiven optischen Element vorgesehen ist.

**10.** Wellenfrontkorrekturelement nach einem der vorhergehenden Ansprüche, **dadurch gekennzeichnet, dass** dieses für eine Arbeitswellenlänge von weniger als 30 nm, insbesondere weniger als 15 nm, ausgelegt ist.

**11.** Spiegel, insbesondere zur Verwendung in einem optischen System einer mikrolithographischen Projektionsbelichtungsanlage oder einer Maskeninspektionsanlage, wobei der Spiegel ein Spiegelsubstrat und einen Reflexionsschichtstapel mit einer Mehrzahl von Schichten aufweist, wobei eine dieser Schichten als Wellenfrontkorrekturelement nach einem der vorhergehenden Ansprüche ausgebildet ist.

**12.** Verfahren zum Herstellen eines Wellenfrontkorrekturelements zur Verwendung in einem optischen System, insbesondere in einem optischen System einer mikrolithographischen Projektionsbelichtungsanlage oder einer Maskeninspektionsanlage, wobei das Verfahren folgende Schritte aufweist:

   • Bereitstellen einer Trägerfolie (110, 210, 410), welche im Betrieb des optischen Systems auf die Trägerfolie (110, 210, 410) auftreffende, eine Arbeitswellenlänge des optischen Systems aufweisende elektromagnetische Strahlung zumindest teilweise transmittiert; und
   • Bearbeiten der Trägerfolie (110, 210, 410) derart, dass eine Variation des Realteils des komplexen Brechungsindex über einen Nutzbereich der Fläche der Trägerfolie (110, 210, 410) erzeugt wird;
   • wobei die Trägerfolie (110, 210, 410) aus einem ersten Material hergestellt wird, welches aus der Gruppe ausgewählt ist, welche Silizium (Si), Zirkon (Zr), Molybdän (Mo), Ruthenium (Ru) und Niob (Nb) enthält, wobei das Bearbeiten der Trägerfolie (110, 210, 410) ein Dotieren mit Fremdatomen (120, 220, 420) eines zweiten Materials, welches von dem ersten Material verschieden ist, umfasst;

   • wobei das Bearbeiten der Trägerfolie (210) ferner ein Dotieren mit Fremdatomen (250) eines dritten Materials, welches von dem ersten Material und dem zweiten Material verschieden ist, umfasst, wobei diese weitere Dotierung eine durch die Fremdatome (120, 220, 420) des zweiten Materials induzierte Variation der Intensität der durch das Wellenfrontkorrekturelement (100, 200, 400) transmittierten elektromagnetischen Strahlung über einen Nutzbereich der Fläche der Trägerfolie (110, 210, 410) wenigstens teilweise kompensiert.

**13.** Optisches System einer mikrolithographischen Projektionsbelichtungsanlage (10), insbesondere Beleuchtungseinrichtung oder Projektionsobjektiv, mit wenigstens einem Wellenfrontkorrekturelement (100, 200, 400) gemäß einem der Ansprüche 1 bis 10.

**14.** Optisches System nach Anspruch 13, **dadurch gekennzeichnet, dass** die Variation des Realteils des Brechungsindex derart ausgestaltet ist, dass im Betrieb des optischen Systems für durch das Wellenfrontkorrekturelement (100, 200, 400) transmittierte elektromagnetische Strahlung eine Wellenfrontmodifikation bewirkt wird, welche eine in dem optischen System vorhandene Wellenfrontaberration wenigstens teilweise korrigiert.

**15.** Mikrolithographische Projektionsbelichtungsanlage (10) mit einer Beleuchtungseinrichtung und einem Projektionsobjektiv, **dadurch gekennzeichnet, dass** die Projektionsbelichtungsanlage (10) ein Wellenfrontkorrekturelement (100, 200, 400) gemäß einem der Ansprüche 1 bis 10 aufweist.

**Claims**

**1.** Wavefront correction element for use in an optical system, in particular in an optical system of a microlithographic projection exposure apparatus or a mask inspection apparatus, comprising:

   • a carrier film (110, 210, 410) which at least partly transmits electromagnetic radiation that has an operating wavelength of the optical system and impinges on the carrier film during the operation of the optical system;
   • wherein the carrier film (110, 210, 310) is configured in such a way that the real part of the complex refractive index varies over a used region of the surface of the carrier film (110, 210, 410);
   • wherein the carrier film (110, 210, 410) is produced from a first material, which is selected from the group containing silicon (Si), zirconium (Zr), molybdenum (Mo), ruthenium (Ru) and niobium (Nb), and wherein the variation of the real part of the refractive index is produced by doping with impurity atoms (120, 220, 420) of a second material;
• wherein the carrier film (110, 210, 410) further has further doping with impurity atoms (250) of a third material, which differs from the first material and the second material, wherein this further doping at least partly compensates a variation in the intensity, induced by the impurity atoms (120, 220, 420) of the second material, of the electromagnetic radiation transmitted through the wavefront correction element (100, 200, 400) over a used region of the surface of the carrier film (110, 210, 410).

2. Wavefront correction element according to Claim 1, **characterized in that** the variation of the real part of the refractive index over a used region of the surface of the carrier film (110, 210, 410) is at least 10%, in particular at least 20%, further in particular at least 30%, respectively in relation to the maximum value of the real part of the refractive index.

3. Wavefront correction element according to Claim 1 or 2, **characterized in that** the doping factor integrated along the thickness of the carrier film (110, 210, 410) varies for the doping with impurity atoms (120, 220, 420) of the second material over a used region of the surface of the carrier film (110, 210, 410).

4. Wavefront correction element according to any one of Claims 1 to 3, **characterized in that** the second material is selected from the group containing molybdenum (Mo), ruthenium (Ru), carbon (C), niobium (Nb) and titanium (Ti).

5. Wavefront correction element according to any one of the preceding claims, **characterized in that** the third material is selected from the group containing germanium (Ge), aluminum (Al), iodine (I), magnesium (Mg) and gallium (Ga).

6. Wavefront correction element according to any one of Claims 1 to 5, **characterized in that** the carrier film (110, 210) has a constant thickness.

7. Wavefront correction element according to any one of Claims 1 to 5, **characterized in that** the carrier film (410) has a thickness profile with a varying thickness.

8. Wavefront correction element according to any one of the preceding claims, **characterized in that** a protective layer (130, 140, 230, 240) is provided on at least one side of the carrier film.

9. Wavefront correction element according to any one of the preceding claims, **characterized in that** the carrier film is provided on a reflective optical element.

10. Wavefront correction element according to any one of the preceding claims, **characterized in that** it is designed for an operating wavelength of less than 30 nm, in particular less than 15 nm.

11. Mirror, in particular for use in an optical system of a microlithographic projection exposure apparatus or a mask inspection apparatus, wherein the mirror has a mirror substrate and a reflection layer stack with a plurality of layers, wherein one of these layers is embodied as a wavefront correction element according to any one of the preceding claims.

12. Method for producing a wavefront correction element for use in an optical system, in particular in an optical system of a microlithographic projection exposure apparatus or a mask inspection apparatus, wherein the method comprises the following steps:

• providing a carrier film (110, 210, 410) which at least partly transmits electromagnetic radiation that has an operating wavelength of the optical system and impinges on the carrier film (110, 210, 410) during the operation of the optical system; and
• processing the carrier film (110, 210, 410) in such a way that a variation of the real part of the complex refractive index is produced over a used region of the surface of the carrier film (110, 210, 410) ;
• wherein the carrier film (110, 210, 410) is produced from a first material, which is selected from the group containing silicon (Si), zirconium (Zr), molybdenum (Mo), ruthenium (Ru) and niobium (Nb), wherein the processing of the carrier film (110, 210, 410) comprises doping with impurity atoms (120, 220, 420) of a second material, which differs from the first material;
• wherein the processing of the carrier film (210) further comprises doping with impurity atoms (250) of a third material, which differs from the first material and the second material, wherein this further doping at least partly compensates a variation in the intensity, induced by the impurity atoms (120, 220, 420) of the second material, of the electromagnetic radiation transmitted through the wavefront correction element (100, 200, 400) over a used region of the surface of the carrier film (110, 210, 410).

13. Optical system of a microlithographic projection exposure apparatus (10), in particular illumination device or projection lens, comprising at least one wavefront correction element (100, 200, 400) according to any one of Claims 1 to 10.

**14.** Optical system according to Claim 13, **characterized in that** the variation of the real part of the refractive index is configured in such a way that, during the operation of the optical system, a wavefront modification which at least partly corrects a wavefront aberration present in the optical system is brought about for electromagnetic radiation that is transmitted through the wavefront correction element (100, 200, 400).

**15.** Microlithographic projection exposure apparatus (10) comprising an illumination device and a projection lens, **characterized in that** the projection exposure apparatus (10) has a wavefront correction element (100, 200, 400) according to any one of Claims 1 to 10.

**Revendications**

**1.** Élément de correction de front d'onde destiné à être utilisé dans un système optique, en particulier dans un système optique d'une installation d'exposition par projection microlithographique ou d'une installation de contrôle de masques, comportant :

    - un film de support (110, 210, 410) qui, pendant le fonctionnement du système optique, transmet au moins en partie un rayonnement électromagnétique incident sur le film de support et présentant une longueur d'onde de fonctionnement du système optique ;
    - dans lequel le film de support (110, 210, 310) est conçu pour faire varier la partie réelle de l'indice de réfraction complexe sur une zone utile de la surface du film de support (110, 210, 410) ;
    - dans lequel le film de support (110, 210, 410) est fabriqué à partir d'un premier matériau choisi dans le groupe constitué par le silicium (Si), le zirconium (Zr), le molybdène (Mo), le ruthénium (Ru) et le niobium (Nb) et dans lequel la variation de la partie réelle de l'indice de réfraction est produite par dopage par des atomes d'impuretés (120, 220, 420) d'un deuxième matériau ;
    - dans lequel le film de support (110, 210, 410) comporte en outre un dopage supplémentaire par des atomes d'impuretés (250) d'un troisième matériau différent du premier matériau et du deuxième matériau, dans lequel ledit dopage supplémentaire compense au moins en partie une variation, induite par les atomes d'impuretés (120, 220, 420) du deuxième matériau, de l'intensité du rayonnement électromagnétique transmis à travers l'élément de correction de front d'onde (100, 200, 400) sur une zone utile de la surface du film de support (110, 210, 410).

**2.** Élément de correction de front d'onde selon la revendication 1, **caractérisé en ce que** la variation de la partie réelle de l'indice de réfraction sur une zone utile de la surface du film de support (110, 210, 410) est respectivement d'au moins 10%, en particulier d'au moins 20% et plus particulièrement d'au moins 30% par rapport à la valeur maximale de la partie réelle de l'indice de réfraction.

**3.** Élément de correction de front d'onde selon la revendication 1 ou 2, **caractérisé en ce que**, pour le dopage par des atomes d'impuretés (120, 220, 420) du deuxième matériau, le degré de dopage intégral le long de l'épaisseur du film de support (110, 210, 410) varie sur une zone utile de la surface du film de support (110, 210, 410).

**4.** Élément de correction de front d'onde selon l'une des revendications 1 à 3, **caractérisé en ce que** le deuxième matériau est choisi dans le groupe constitué par le molybdène (Mo), le ruthénium (Ru), le carbone (C), le niobium (Nb) et le titane (Ti).

**5.** Élément de correction de front d'onde selon l'une des revendications précédentes, **caractérisé en ce que** le troisième matériau est choisi dans le groupe constitué par le germanium (Ge), l'aluminium (Al), l'iode (1), le magnésium (Mg) et le gallium (Ga).

**6.** Élément de correction de front d'onde selon l'une des revendications 1 à 5, **caractérisé en ce que** le film de support (110, 210) présente une épaisseur constante.

**7.** Élément de correction de front d'onde selon l'une des revendications 1 à 5, **caractérisé en ce que** le film de support (410) présente un profil d'épaisseur ayant une épaisseur variable.

**8.** Élément de correction de front d'onde selon l'une des revendications précédentes, **caractérisé en ce qu'**il est prévu une couche de protection (130, 140, 230, 240) sur au moins une face du film de support.

**9.** Élément de correction de front d'onde selon l'une des revendications précédentes, **caractérisé en ce que** le film de support est prévu sur un élément optique réfléchissant.

**10.** Élément de correction de front d'onde selon l'une des revendications précédentes, **caractérisé en ce qu'**il est conçu pour une longueur d'onde de fonctionnement inférieure à 30 nm, en particulier inférieure à 15 nm.

**11.** Miroir, en particulier destiné à être utilisé dans un système optique d'une installation d'exposition par projection microlithographique ou d'une installation de contrôle de masques, dans lequel le miroir comporte un substrat de miroir et un empilement de couches réfléchissantes comportant une pluralité de couches, dans lequel l'une desdites couches est réalisée sous la forme d'un élément de correction de front d'onde selon l'une des revendications précédentes.

12. Procédé de fabrication d'un élément de correction de front d'onde destiné à être utilisé dans un système optique, en particulier dans un système optique d'une installation d'exposition par projection microlithographique ou d'une installation de contrôle de masques, dans lequel le procédé comprend les étapes suivantes :

- la fourniture d'un film de support (110, 210, 410) qui, pendant le fonctionnement du système optique, transmet au moins en partie un rayonnement électromagnétique incident sur le film de support (110, 210, 410) et présentant une longueur d'onde de fonctionnement du système optique ; et
- le traitement du film de support (110, 210, 410) de manière à produire une variation de la partie réelle de l'indice de réfraction complexe sur une zone utile de la surface du film de support (110, 210, 410) ;
- dans lequel le film de support (110, 210, 410) est fabriqué à partir d'un premier matériau choisi dans le groupe constitué par le silicium (Si), le zirconium (Zr), le molybdène (Mo), le ruthénium (Ru) et le niobium (Nb), dans lequel le traitement du film de support (110, 210, 410) comprend un dopage par des atomes d'impuretés (120, 220, 420) d'un deuxième matériau différent du premier matériau ;
- dans lequel le traitement du film de support (210) comprend en outre un dopage par des atomes d'impuretés (250) d'un troisième matériau différent du premier matériau et du deuxième matériau,

dans lequel ledit dopage supplémentaire compense au moins en partie une variation, induite par les atomes d'impuretés (120, 220, 420) du deuxième matériau, de l'intensité du rayonnement électromagnétique transmis à travers l'élément de correction de front d'onde (100, 200, 400) sur une zone utile de la surface du film de support (110, 210, 410).

13. Système optique d'une installation d'exposition par projection microlithographique (10), en particulier dispositif d'éclairage ou lentille de projection, comportant au moins un élément de correction de front d'onde (100, 200, 400) selon l'une des revendications 1 à 10.

14. Système optique selon la revendication 13, **caractérisé en ce que** la variation de la partie réelle de l'indice de réfraction est telle que, lors du fonctionnement du système optique, pour un rayonnement électromagnétique transmis à travers l'élément de correction de front d'onde (100, 200, 400), une modification produite du front d'onde corrige au moins en partie une aberration du front d'onde présente dans le système optique.

15. Installation d'exposition par projection microlithographique (10) comprenant un dispositif d'éclairage et un objectif de projection, **caractérisé en ce que** l'installation d'exposition par projection (10) comporte un élément de correction de front d'onde (100, 200, 400) selon l'une des revendications 1 à 10.

# Fig. 1

# Fig. 2

## Fig. 3

## Fig. 4

EP 3 286 595 B1

## Fig. 5a

**Fig. 5b**

**Fig. 6**

EP 3 286 595 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102015207153

- WO 2013117343 A1

**In der Beschreibung aufgeführte Nicht-Patentliteratur**

- **D. T. ATTWOOD.** Soft X-Rays and Extreme Ultraviolet Radiation: Principles and Applications. Cambridge University Press, 2000
- **H. RYSSEL ; I. RUGE.** Ion Implantation. J. Wiley & Sons, 1986

- **J.J. CUOMO ; S.M. ROSSNAGEL ; HR KAUFMAN.** Handbook of ion beam processing technology. Noyes Publications, 1989